# EUROPEAN PATENT SPECIFICATION

(11) **EP 2 426 136 B1**
(45) Date of publication and mention of the grant of the patent: **01.05.2013**
(21) Application number: 10305955.6
(22) Date of filing: 03.09.2010
(51) Int. Cl.: C07F 5/06, C23C 16/455, H01L 31/0216

(54) **Use of trialkylaluminum for the growth of Al2O3 thin films for photovoltaic applications**
Verwendung von Trialkylaluminium für das Wachstum von Al2O3-Dünnfilmen für photovoltaische Anwendungen
Utilisation de trialkylaluminum pour la croissance de films minces de Al2O3 pour des applications photovoltaïques

(43) Date of publication of application: 07.03.2012
(73) Proprietor: L'AIR LIQUIDE, SOCIETE ANONYME POUR L'ETUDE ET L'EXPLOITATION DES PROCEDES GEORGES CLAUDE, 75007 Paris (FR); Technische Universiteit Eindhoven, 5612 AZ Eindhoven (NL)
(72) Inventor: Lachaud, Christophe, 91240, SAINT-MICHEL SUR ORGE (FR); Blasco, Nicolas, 38000, GRENOBLE (FR); Madec, Alain, 91140, VILLEBON S/YVETTE (FR); Kessels, Wilhelmus Mathijs Marie, 5045 ZZ, TILBURG (NL); Dingemans, Gijs, 5021 VX, TILBURG (NL)
(74) Representative: Grout de Beaufort, François-Xavier

(56) References cited:
- DE-A1-102009 003 467
- US-A1- 2010 090 218
- DINGEMANS G ET AL: "Silicon surface passivation by ultrathin Al2O3 films synthesized by thermal and plasma atomic layer deposition", PHYSICA STATUS SOLIDI - RAPID RESEARCH LETTERS 2010 WILEY-VCH VERLAG DEU, vol. 4, no. 1-2, February 2010 (2010-02), pages 10-12, XP002619642, DOI: DOI:10.1002/PSSR.200903334
- POODT P ET AL: "High-speed spatial atomic-layer deposition of aluminum oxide layers for solar cell passivation", ADVANCED MATERIALS 20100824 WILEY-VCH VERLAG DEU, vol. 22, no. 32, 24 August 2010 (2010-08-24), pages 3564-3567, XP002619643, DOI: DOI:10.1002/ADMA.201000766
- HEMMEN VAN J L ET AL: "PLASMA AND THERMAL ALD OF AL2O3 IN A COMMERCIAL 200 MM ALD REACTOR", JOURNAL OF THE ELECTROCHEMICAL SOCIETY, PHILADELPHIA, US, US, vol. 154, no. 7, 1 July 2007 (2007-07-01), pages G165-G169, XP001544016,

## Description

The present invention concerns the use of a composition of Trialkylaluminium containing metal impurities, useful for the deposition of thin films in photovoltaic technologies, in particular for solar cells.

The photovoltaic effect is known since the end of the 19^{th} century. The principle consists in converting light energy into electricity. In the current ecological context, this is a promising solution to produce clean and renewable energy. One of the reasons for the slow development of photovoltaic electricity up to now is its lack of competitiveness compared to the traditional solutions such as coal, fossil fuels or nuclear based electricity. So the contribution of solar electricity as one significant component of the future energy mix is bounded to the capability to continue the cost per watt peak reduction race. To reach this goal, reduction of the manufacturing costs and improvement of cell's efficiency are two solutions.

Reduction of the manufacturing costs is addressed for example with thinner wafers usage to limit the impact of silicon feedstock price on the overall cell's cost (in 2010, cost split is 55 % for wafer - with 23 % for silicon feedstock, 13 % for silicon growth and 18 % for wafering step - and 45 % for cell processing), and in general with reduced raw materials consumption, including chemicals used during each step of the manufacturing. This manufacturing cost decrease is driven by manufacturing tools providers (the OEM - Original Equipment Manufacturers) and by material suppliers.

Improvement of photovoltaic cell's efficiency requires innovation activity that takes place in the Research laboratories. The passivation phenomenon related work carried out by academics may contribute to the enhancement of the photovoltaic cell's performance. Passivation of the cell's defects by for example hydrogen increases the efficiency of the cell by reducing the probability of hole-electron pairs' recombination at the surface and in the bulk of the silicon: the lower the number of defects into the material the higher the probability that charge carriers are collected. These recombinations take place on the front side of the solar cell as well as on the backside. To prevent the backside recombination, the deposition of a thin Al₂O₃ layer has been described in the literature (for example P.Vitanov and al. "Chemical Deposition of Al2O3 thin films on Si substrates" Thin Solid Films, 517 (2009), 6327-6330) as well as Hoex et al. "Silicon surface passivation by atomic layer deposited Al2O3" JOURNAL OF APPLIED PHYSICS 104, 044903 2008_demonstrated that very thin ALD- Al₂O₃ layers (5-30 nm) can provide an excellent surface passivation for n-type and p-type silicon wafers after annealing at 425°C. This layer contributes to passivation in two ways: reduction of interface defects density and field-effect passivation thanks to high negative charge density at the silicon - alumina interface (G. Dingemans, R. Seguin, P. Engelhart, M.C.M. van de Sanden and W.M.M. Kessels; "silicon surface passivation by ultrathin Al2O3 films synthesized by thermal and plasma atomic layer deposition"; Phys. Status Solidi RRL4, N° 1-2, 10-12 (2010)).

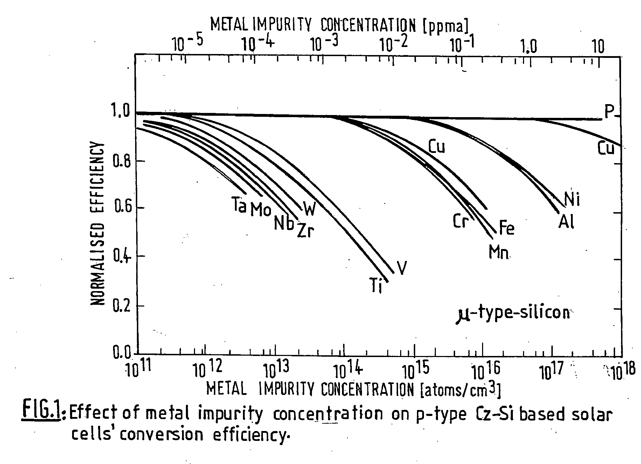

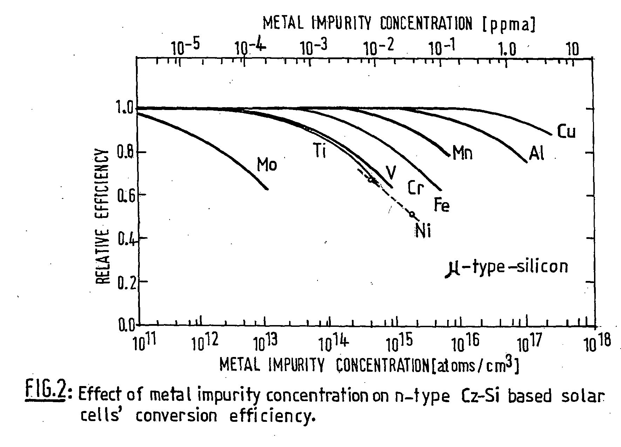

Recombination also occurs in the bulk of the silicon. Therefore, for an effective collection of the carriers, their diffusion length (average distance covered by a charge carrier before it gets recombined) or lifetime should be at least equal to the wafer thickness (V.G. Litovchenko, N.I. Klyuis, A.A. Evtukh, A.A. Efremov, A.V. Sarikov, et al.; "Solar cells prepared on multicrystalline silicon subjected to new gettering and passivation treatments"; Solar Energy Materials and Solar Cells, 72 (2002), 343-351). Injection of atomic hydrogen to passivate the defects and reduction of the amount of metallic impurities into the bulk are two major solutions to increase diffusion length. Several sources of contamination can be identified during the different manufacturing steps: from the silicon wafer production, including the silicon ingot or silicon casting steps, to the solar cell fabrication where lots of chemicals are used. The detrimental impact of some impurities such as copper or iron on the lifetime of charge carriers is known thanks to studies carried out for the semiconductor industry. Figure 1 and Figure 2 detail conversion efficiency of p-type and n-type wafers based solar cells depending on concentration of selected metallic impurities.

Figure 1 shows the effect of metal impurity concentration on p-type Cz-Si based solar cells' conversion efficiency.

Figure 2 shows the effect of metal impurity concentration on n-type Cz-Si based solar cells' conversion efficiency.

The detrimental effect of iron in a boron doped (p-type) silicon wafer is described by Zoth et al ("Silicon contamination control by lifetime measurements"; in Analytical and Diagnostic Techniques for Semiconductor Materials, Devices and Processes (eds. Kolbesen et al.), The Electrochemical Society proceedings, volume ECS PV 99-16 (1999)). During the high temperature firing step (about 800°C) required by most solar cell manufacturing processes, iron atoms, also those possibly and unintentionally deposited with the Al₂O₃, will be scattered uniformly into the silicon bulk due to diffusion phenomena. These atoms will be located on interstitial sites and some of them will combine reversibly with a boron atom. Injection of minority carrier in silicon by photo excitation will dissociate the FeB pairs and therefore interstitial iron atoms will become recombination centers which are ten times stronger than FeB.

Iron will also form an oxide, when oxygen is present in the bulk. This oxide is an additional defect in the structure and then a recombination center.

Other metallic impurities such as copper and nickel will have an impact on the surface of the wafer where they will precipitate and form recombination centers. Titanium and molybdenum will diffuse slowly into the bulk and form active recombination centers after high temperature firing.

To conclude, experts of silicon science consider that transition metals, more precisely iron, copper, tantalum or molybdenum, are particularly detrimental to the global performance of solar cells (A.A. Istratov, C. Flink, H. Hieslmair, S.A. McHugo, E.R. Weber; "Diffusion, solubility and gettring of copper in silicon"; Materials Science and engineering B72 (2000) 99-104).

It is easily understood that impurities can be introduced during the wafer processing itself or during handling. During solar cells' manufacturing, contamination can result from usage of inappropriate grade chemicals. In a CVD process for example, these undesirable elements will be transferred in the gas phase with the main compounds and then incorporated into the layers to be deposited, more precisely, in the passivation layers.

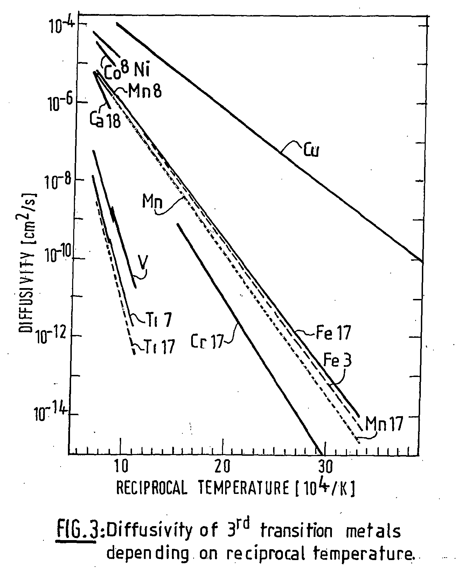

Based on the above information resulting from extensive experience of the scientific community, it is obvious that Al₂O₃ deposition - for surface of silicon wafer based solar cells - performed by ALD, i.e Atomic Layer Deposition, or MOCVD, i.e Metal-Organic Chemical Vapor Deposition (Agostinelli et al. "Very Low surface recombination velocities on p-type silicon wafers passivated with a dielectric with fixed negative charge"; Solar Energy Materials & Solar Cells, 90 (2006), 3438-3443), or PECVD, i.e. Plasma Enhanced Chemical Vapor Phase Deposition (Saint-Cast et al., Very low surface recombination velocity on p-type c-Si by high-rate plasma-deposited aluminum oxide, APPLIED PHYSICS LETTERS 95, 151502 _2009) or any other vapor-phase deposition technique can induce incorporation of impurities in the deposited layer, these impurities are to be found originally in the aluminium source precursor, usually trimethylaluminum (TMA), but alternatively a trialkylaluminum such as triethylaluminum (TEA), used for such deposition processes. One could argue that the impurities would be segregated into the passivation alumina layer but this consideration does not take into account that each metallic impurity has a specific diffusion factor and that this diffusion phenomenon from the alumina layer to the silicon bulk increases with temperature. Therefore, the more contaminated the passivation layer, the more contaminated the silicon due to enhancement of diffusion during the mandatory annealing or other high temperature steps (see Figure 3).

Table 1 details typical impurity upper limits concentrations and requirements for trimethylaluminum precursor to be used in the electronics industry (for example, MOCVD of epitaxial AlGaAs, AlGaN and InAlGaP films for applications in products such as high brightness LEDs and lasers and more recently ALD of aluminium oxide, which is the dielectric layer of choice in DRAM devices). These limits are based on process chemical guidelines (SEMI C66-0308 - Guidelines for Trimethylaluminium (TMAI), 99.5% Quality) approved by the global Liquid Chemicals Committee and available since February 2008. These guidelines give appropriate metal and general contamination information to assist end users and chemical manufacturers. If the quantity of one of the impurities is superior to the present limit, the TMA precursor does not meet the requirements for usage in the manufacturing of a semiconductor. The grad as defined in table 1 is named "semiconductor grade" in the present description.

**Table 1: Typical impurities concentration in semiconductor grade trimethylaluminum precursor**

| | | Semiconductor grade (ppbw) |
|---|---|---|
| B | Boron | < 100 |
| Ca | Calcium | < 50 |
| Cr | Chromium | < 50 |
| Cu | Copper | < 150 |
| Fe | Iron | < 80 |
| K | Potassium | < 50 |
| Na | Sodium | < 30 |
| Ni | Nickel | < 50 |
| Zn | Zinc | < 100 |
| Ti | Titanium | < 50 |
| Mn | Manganese | < 50 |
| Co | Cobalt | < 50 |

Data of Table 1 and the above discussion encourage a solar cell manufacturer to use "semiconductor grade" TMA to avoid any risk of contamination and therefore any possible degradation of the cells' efficiency: A "non-semiconductor grade" TMA usage for deposition of Al₂O₃ surface passivation layer could be a non-negligible source of contamination with strong lifetime killers such as iron or copper.

Al₂O₃ is used in the semiconductor industry for several applications such as passivation and electrical insulation. For these applications, "semiconductor grade" aluminum precursor is commonly used to avoid any metallic impurities potentially generating undesirable phenomena such as leakage currents.

Nevertheless, the inventors of the present invention show that astonishingly the usage of a non-semiconductor grade aluminum precursor can be used for deposition of a surface passivation layer in crystalline silicon wafer based solar cells manufacturing as such non-semiconductor grade chemical usage does not induce any observable deterioration of the cell's performance (evaluated for example with the measurement of the lifetime carrier). Another application of the non-semiconductor grade trialkylaluminum could be the deposition of Al₂O₃ for encapsulation of photovoltaic devices.

The present invention concerns the use of a composition as indicated in claim 1.

According one embodiment of the invention, the composition as defined above comprises also:
- From 5000 ppb to 10 ppm of Ni (Nickel);
- From 2000 ppb to 10 ppm of Zn (Zinc);
- From 5000 ppb to 10 ppm of W (Tungsten).

According another embodiment of the invention the composition as defined above comprises other metal impurities such as B (Boron), Ca (Calcium), K (Potassium), Cr (Chromium), Na (Sodium), Nb (Niobium), Ti (Titanium), Mn (Manganese), Co (Cobalt), Sn (Tin) in a quantity comprised between 0 and 20ppm for each of them.

According to another embodiment of the invention, the Trialkylaluminium is selected from Trimethylaluminum and Triethylaluminum.

According another embodiment, the invention concerns the use of a composition as defined above for a thin film deposition method by ALD, PEALD, CVD, PECVD or MOCVD.

According another embodiment, the invention concerns the use as defined above, wherein the deposition method is an ALD method.

According another embodiment, the invention concerns the use as defined above wherein the composition as defined above comprises from 97% to 99,4% of Trialkylaluminium selected from Trimethylaluminum and Triethylaluminum.

According another embodiment, the invention concerns the use as defined above for the encapsulation of photovoltaic devices, in particular for solar cells.

From the background of the invention, the inventors understood that a "semiconductor grade" aluminum precursor was mandatory for specific applications but they have concluded that surprisingly a "non semiconductor grade" trialkylaluminum can be used for the purpose of depositing a surface passivation alumina layer for crystalline silicon wafer based photovoltaic solar cell. Actually, the examples detailed below show that contrary to what was expected, usage of "non semiconductor grade" aluminum precursor (chemical with enlarged tolerance on the amount of impurities than "semiconductor grade" one) is a suitable technical solution to achieve performance meeting the photovoltaic solar cells' expectations. Also for any photovoltaic devices, encapsulation issues can be addressed by Atomic Layer Deposition or any other suitable vapor phase deposition technique of Al₂O₃ deposited with "non-semiconductor" grade trialkylaluminum.

This chemical with such grade has the advantages of allowing deposition of Al₂O₃ layers for passivation by ALD, MOCVD, PECVD or any other derivative deposition methods without observable degradation of the performance of the solar cell (evaluated with minority carrier lifetime measurements). Furthermore, for encapsulation purposes, ALD or any other derivative deposition methods can be considered to fabricate an Al₂O₃ film from such "non-semiconductor grade" chemicals.

This novel intermediate grade precursor's usage is not solely limited to the deposition of a surface passivation layer for crystalline silicon wafer based photovoltaic solar cell but its benefit could be applied to other manufacturing steps in the photovoltaic industry such as encapsulation process. As well, such lower grade aluminium precursors could be used in various other application fields.

The deposition of an Al₂O₃ thin film requires several steps:
a. Vaporizing the trialkylaluminum source to form an aluminum source gas phase.
b. Introducing several precursors in vapor phase in a deposition device, wherein said precursors comprise said vaporized trialkylaluminum source, and oxygen source without limitation oxygen, carbon dioxide or nitrogen dioxide plasma, ozone, oxygen, water.

In one embodiment of the invention, the vaporization of the new precursor "non-semiconductor grade" can be performed by introducing a gas in a canister containing the said trialkylaluminum "non-semiconductor grade" source. The canister is preferably heated at a temperature which allows to vaporize the said source with a sufficient vapor pressure. The carrier gas can be selected from Ar, He, H₂, N₂ or mixtures of them. The canister can for instance be heated at temperatures in the range of 15°C to 170°C. The temperature can be adjusted to control the amount of precursor in the gas phase.

In another embodiment of the invention, the said trialkylaluminum "non-semiconductor grade" source is fed in the liquid state to a vaporizer where it is vaporized.

In one embodiment of the invention, the pressure in the said canister is in the range from 133 mPa to 133.10² Pa.

The said vaporized metal source is introduced into a reaction chamber where it is contacted to a solar cell substrate. The substrate can be covered with a material from the group Si, SiO₂, SiN, SiON, and other silicon containing substrates and films and even other metal containing films. The substrate can be heated to sufficient temperature to obtain the desired film at sufficient growth rate and with desired physical state and composition. Typical temperature range from room temperature to 600°C and preferably from 150°C to 600°C. Preferably the temperature is lower or equal to 450°C. The pressure in the reaction chamber is controlled to obtain the desired metal containing film at sufficient growth rate. The typical pressures range from 133 mPa to 133.10² Pa or higher.

In one embodiment of the invention, the said trialkylaluminum "non-semiconductor grade" source described above is mixed to one or more reactant species prior to the reaction chamber.

In one embodiment of the invention, the said trialkylaluminum "non-semiconductor grade" source described above is mixed to one or more reactant species in the reaction chamber.

In another embodiment of the invention, the said trialkylaluminum non semiconductor grade source and the reactant species are introduced sequentially in the reaction chamber. The trialkylaluminum "non-semiconductor grade" source and the reactant species can be introduced simultaneously (chemical vapor deposition), sequentially (atomic layer deposition) or different combinations (one example is to introduce the reactant species (one example could be oxygen) continuously and to introduce trialkylaluminum "non-semiconductor grade" source by pulse (pulsed-chemical vapor deposition).

In one embodiment of the invention, the reactant species are decomposed into radicals in a plasma system prior to entering in the reaction chamber.

In one embodiment of the invention the said reactant species include an oxygen source which is selected from oxygen (O₂), oxygen-containing radicals (for instance O or OH), for instance generated by an oxygen (O₂), carbon dioxide (CO₂) or nitrogen dioxide (NO₂) plasma, ozone (O₃), moisture (H₂O) and H₂O₂.

In one embodiment of the invention, the said trialkylaluminum "non-semiconductor grade" source is used for atomic layer deposition of Al₂O₃ films. The said aluminum source and the reactant species are introduced sequentially in the reaction chamber (atomic layer deposition). The reactor pressure is selected in the range from 133 mPa to 133.10² Pa. Preferably the reactor pressure is comprised between 133 Pa and 1330 Pa. A purge gas is introduced between the metal source pulse and the reactant species pulse. The purge gas can be selected without limitation from the group consisting of N₂, Ar, He. The aluminum source, purge gas and reactant species pulse duration is comprised between 1ms and 10 seconds. The pulse duration is preferably about 10 ms.

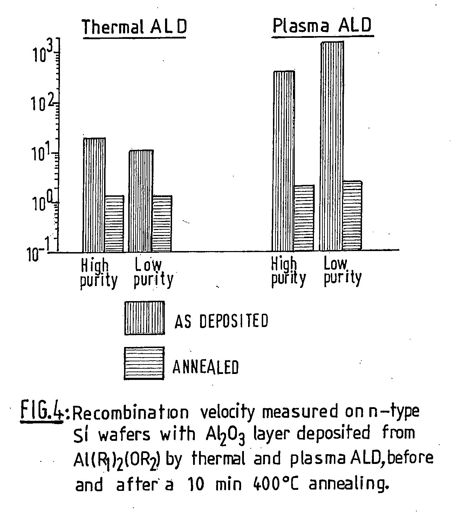

Now, the present invention will be explained with reference to examples.
1) Al₂O₃ thin film deposited by thermal ALD from a trimethylaluminum grade source used according to the present invention.
   Trimethylaluminum (TMA) grade used according to the present invention is stored into a canister. The canister is maintained at room temperature (20°C). Water is used as oxygen source. The silicon substrate is heated at 200°C. TMA is vapour drawn but nitrogen can optionally be used as a carrier gas at a flow of about for example 50 sccm. The aluminum precursor is sequentially introduced into the reaction chamber with water. During the first step, a pulse of trimethylaluminum is introduced during 20ms, followed by an optional 3.5 s argon purge. A pulse of water is then introduced into the reaction chamber during 20 ms, followed by the optional 3.5 s argon purge. This first sequence is then repeated 1000 times. An Al₂O₃ film meeting the electrical properties requirements (charge carrier lifetime of silicon substrate) for photovoltaic applications is obtained. Such a good result shows that the usage of a "non-semiconductor grade" is possible for deposition of an Al₂O₃ layer having proficient passivation properties.
2) Al₂O₃ thin film deposited by plasma ALD from a trimethylaluminum grade source used according to the present invention.
   Trimethylaluminum (TMA) grade used according to the present invention is stored into a canister. The canister is maintained at room temperature (20°C). Oxygen plasma is used as oxygen source (TMA will not react with oxygen gas under the conditions below). Oxygen gas is continuously introduced at a flow of 50sccm. The silicon substrate is heated at 200°C. TMA is vapour drawn but nitrogen can optionally be used as a carrier gas at a flow of about for example 50 sccm. The aluminum precursor is sequentially introduced into the reaction chamber. During the first step, a pulse of trimethylaluminum is introduced during 20ms, followed by an optional 3.5 s argon purge. A pulse of plasma is generated into the reaction chamber during 3 s to produce oxygen plasma, followed by the optional 0.5 s argon purge. This first sequence is then repeated 1000 times. An Al₂O₃ film meeting the electrical properties requirements (charge carrier lifetime of silicon substrate) for photovoltaic applications is obtained. Such a good result shows that the usage of a "non-semiconductor grade" is possible for deposition of an Al₂O₃ layer having proficient passivation properties.
3) Deposition tests were performed with a "semiconductor grade" (the highest grade available, see Table 1 for some typical impurity levels) and a "non-semiconductor grade" (see Table 2) TMA samples. Resulting recombination velocities of minority carriers (before and after a 400°C annealing step) are given (see Figure 4) for 20 nm thick Al₂O₃ layer deposited by thermal ALD and plasma ALD using a "semiconductor grade" (highest purity) and a "non-semiconductor grade" according to the present invention. Figure 4 shows that the results of the Al₂O₃ layer deposited from TMA by "non-semiconductor grade" used according to the present invention are equivalent to the results of the Al₂O₃ layer deposited from TMA by "semiconductor grade".

**Table 2: Typical impurities concentration in non-semiconductor grade trimethylaluminum precursor.**

| | | Non-Semiconductor grade of the invention (ppbw) |
|---|---|---|
| B | Boron | 5,000 |
| Ca | Calcium | 5,000 |
| Cr | Chromium | 5,000 |
| Cu | Copper | 5,000 |
| Fe | Iron | 3,000 |
| K | Potassium | 10,000 |
| Na | Sodium | 6,000 |
| Ni | Nickel | 10,000 |
| Zn | Zinc | 10,000 |
| Ti | Titanium | 5,000 |
| Sn | Tin | 5,000 |
| Mo | Molybdenum | 2,000 |
| Ta | Tantalum | 2,000 |
| W | Tungsten | 10,000 |

**Table 3: Typical impurities concentration in non-semiconductor grade trimethylaluminum precursor.**

| | | Min (ppbw) | Recommended values (ppbw) | Max (ppbw) |
|---|---|---|---|---|
| B | Boron | 0 | 5000 | 20000 |
| Ca | Calcium | 0 | 5000 | 20000 |
| Cr | Chromium | 0 | 5000 | 20000 |
| Cu | Copper | 2000 | 5000 | 5000 |
| Fe | Iron | 1000 | 3000 | 5000 |
| K | Potassium | 0 | 10000 | 20000 |
| Na | Sodium | 0 | 6000 | 20000 |
| Ni | Nickel | 5000 | 10000 | 10000 |
| Zn | Zinc | 2000 | 10000 | 10000 |
| Ti | Titanium | 0 | 5000 | 20000 |
| Sn | Tin | 0 | 5000 | 20000 |
| Mo | Molybdenum | 200 | 2000 | 5000 |
| Ta | Tantalum | 200 | 2000 | 5000 |
| W | Tungsten | 500 | 10000 | 10000 |
| Nb | Niobium | 0 | 10000 | 20000 |
| Mn | Manganese | 0 | 5000 | 20000 |
| Co | Cobalt | 0 | 5000 | 20000 |

Taking into consideration the background of the invention, the conclusion of these tests is very surprising and it opens up a new possibility for manufacturing of crystalline silicon wafer based photovoltaic solar cells thanks to this innovative "non-semiconductor grade" trialkylaluminum solution for deposition of surface passivation alumina layer. Also for any photovoltaic devices, encapsulation issues can be addressed by Atomic Layer Deposition of Al₂O₃ deposited with "non-semiconductor grade" trialkylaluminum.

It was demonstrated that the deposition of Al₂O₃ for passivation can be performed from a "non-semiconductor grade" of trialkylaluminum such as TMA and TEA as aluminum source without observable degradation of the crystalline silicon wafer based photovoltaic solar cells' performance; and more precisely without harming the passivation capability of the surface alumina layer.

## Claims

1. Use of a composition comprising, for 100% of its total mass, at least 97% of a Trialkylaluminium and :
- From 200 ppb to 5 ppm of Mo (Molybdenum);
- From 1000 ppb to 5 ppm of Fe (Iron);
- From 200 ppb to 5 ppm of Cu (Copper);
- From 200 ppb to 10 ppm of Ta (Tantalum),
for a thin film of Aℓ₂O₃ deposition for crystalline silicon wafer based photovoltaic solar cells.

2. Use of claim 1 wherein the composition comprises also :
- From 5000 ppb to 10 ppm of Ni (Nickel);
- From 2000 ppb to 10 ppm of Zn (Zinc);
- From 5000 ppb to 10 ppm of W (Tungsten).

3. Use of claim 1 or 2 wherein the composition comprises other metal impurities such as B (Boron), Ca (Calcium), K (Potassium), Cr (Chromium), Na (Sodium), Nb (Niobium), Ti (Titanium), Mn (Manganese), Co (Cobalt), Sn (Tin) in a quantity comprised between 0 and 20ppm for each of them.

4. Use of any of claims 1 to 3, wherein the Trialkylaluminium is selected from Trimethylaluminum and Triethylaluminum.

5. Use as defined in anyone of claims 1 to 4 for a thin film deposition method by ALD, PEALD, CVD, PECVD or MOCVD.

6. Use according to claim 5, wherein the deposition method is an ALD method.

7. Use according to anyone of claims 1 to 6 wherein the composition comprises from 97% to 99,4% of Trialkylaluminium selected from Trimethylaluminum and Triethylaluminum.

## Patentansprüche

1. Verwendung einer Zusammensetzung, die auf 100 % ihrer Gesamtmasse mindestens 97 % eines Trialkylaluminiums und:
- von 200 ppb bis 5 ppm Mo (Molybdän);
- von 1000 ppb bis 5 ppm Fe (Eisen);
- von 200 ppb bis 5 ppm Cu (Kupfer);
- von 200 ppb bis 10 ppm Ta (Tantal)
umfasst, für eine Al₂O₃-Abscheidungsdünnschicht für photovoltaische Zellen auf Basis von Wafern aus kristallinem Silizium.

2. Verwendung nach Anspruch 1, wobei die Zusammensetzung außerdem:
- von 5000 ppb bis 10 ppm Ni (Nickel);
- von 2000 ppb bis 10 ppm Zn (Zink);
- von 5000 ppb bis 10 ppm W (Wolfram)
umfasst.

3. Verwendung nach Anspruch 1 oder 2, wobei die Zusammensetzung andere Metallverunreinigungen, wie B (Bor), Ca (Calcium), K (Kalium), Cr (Chrom), Na (Natrium), Nb (Niob), Ti (Titan), Mn (Mangan), Co (Kobalt), Sn (Zinn), in einer Menge umfasst, die zwischen 0 und 20 ppm für jede dieser liegt.

4. Verwendung nach einem der Ansprüche 1 bis 3, wobei das Trialkylaluminium aus Trimethylaluminium und Triethylaluminium ausgewählt ist.

5. Verwendung nach einem der Ansprüche 1 bis 4 für ein Dünnschichtabscheidungsverfahren durch ALD, PEALD, CVD, PECVD oder MOCVD.

6. Verwendung nach Anspruch 5, wobei das Abscheidungsverfahren ein ALD-Verfahren ist.

7. Verwendung nach einem der Ansprüche 1 bis 6, wobei die Zusammensetzung von 97 % bis 99,4 % Trialkylaluminium umfasst, das aus Trimethylaluminium und Triethylaluminium ausgewählt ist.

## Revendications

1. Utilisation d'une composition comprenant, pour 100 % de sa masse totale, au moins 97 % d'un trialkylaluminium et
- de 200 ppb à 5 ppm de Mo (molybdène) ;
- de 1000 ppb à 5 ppm de Fe (fer) ;
- de 200 ppb à 5 ppm de Cu (cuivre) ; et
- de 200 ppb à 5 ppm de Ta (tantale),
pour le dépôt d'un film mince d'Al₂O₃ pour des piles solaires photovoltaïques à base d'une tranche de silicium cristallin.

2. Utilisation selon la revendication 1, dans laquelle la composition comprend également :
- de 5000 ppb à 10 ppm de Ni (nickel) ;
- de 2000 ppb à 10 ppm de Zn (zinc) ; et
- de 5000 ppb à 10 ppm de W (tungstène).

3. Utilisation selon la revendication 1 ou la revendication 2, dans laquelle la composition comprend d'autres impuretés métalliques telles que B (bore), Ca (calcium), K (potassium), Cr (chrome), Na (sodium), Nb (niobium), Ti (titane), Mn (manganèse), Co (cobalt), Sn (étain) en quantité comprise entre 0 et 20 ppm pour chacune d'entre elles.

4. Utilisation selon les revendications 1 à 3, dans laquelle le trialkylaluminium est choisi parmi le triméthylaluminium et le triéthylaluminium.

5. Utilisation telle que définie dans l'une quelconque des revendications 1 à 4 pour un procédé de dépôt en film mince par ALD, PEALD, CVD, PECVD ou MOCVD.

6. Utilisation selon la revendication 5, dans laquelle le procédé de dépôt est un procédé ALD.

7. Utilisation selon l'une quelconque des revendications 1 à 6, dans laquelle la composition comprend 97 % à 99,4 % de trialkylaluminium choisi parmi le triméthylaluminium et le triéthylaluminium.
